# EUROPEAN PATENT APPLICATION

(11) **EP 3 199 961 A1**
(43) Date of publication of application: **02.08.2017**
(21) Application number: 17153594.1
(22) Date of filing: 27.01.2017
(51) Int. Cl.: G01R 31/08, G01R 31/11, G01N 27/20

(54) **METHOD AND DEVICE FOR DETECTING AND LOCALIZING ABNORMALITIES IN A POWER CABLE**

(30) Priority: 28.01.2016 NL 2016171
(71) Applicant: Technolution B.V., 2803 WV Gouda (NL)
(72) Inventor: Doesburg, Mark Johan Stevin, 2841 SV MOORDRECHT (NL); Honkoop, Olaf Martijn, 3951 AB MAARN (NL); Roggekamp, Winifred Egbert Jozef, 3329 LD DORDRECHT (NL)
(74) Representative: Land, Addick Adrianus Gosling

(57) **Abstract**

The invention relates to a method and device for detecting abnormalities in a power cable which is in use and which comprises a plurality of conductive cores, the method comprising of dividing the power cable of a determined length into a number of cable sections of shorter length; determining a section pattern of signals occurring in a section when the insulation of a core shows an abnormality, wherein the section pattern is determined for each cable section in that the signals are present at different times in the measured value; measuring the magnitude of signals, measured in the magnetic field originating from the cable, over time in a determined frequency band; and designating a cable section with an abnormality when the measured signals match the section pattern determined for the cable section, wherein the signals are measured in a common mode and/or one or more differential modes of the conductive cores.

## Description

In use in many countries is an electricity grid which connects users to producers. An electricity grid usually consists of different voltage levels. The lowest level is a low-voltage network (e.g. 110 or 230 V) which for instance provides houses with electricity. This network is supplied by converting electricity with a higher voltage to low voltage using transformers which are located in transformer substations. The transformers are supplied from a medium voltage cable with a voltage of for instance 10 kV. The medium voltage network is then connected to a transformer which converts high voltage from the high-voltage network (e.g. 100 kV or higher) to medium voltage.

It will be apparent that for these networks a very large number of power cables are in use on which maintenance also has to be carried out. Determining whether the cables, or parts of the cables, need replacing is usually based on estimations. Medium voltage cables generally lie below ground here, whereby visual inspection is particularly labour-intensive. Complete cables are as a result generally replaced at times determined by estimation, whereby excavation over several hundred metres is generally necessary per cable. In addition to normal ageing of the cables, mechanical load (e.g. due to subsidence, construction operations, tree roots etc.) can also cause kinks in the cable or other damage. Leakage of current may for instance hereby increase, the cable can short-circuit and/or become unusable. Estimating the lifespan is further made more difficult by the increasingly larger amount of locally generated current, such as by solar cells. The cables are not designed for the heavy and/or highly fluctuating load caused hereby. In addition to the lifespan being shortened as a result, the lifespan will also become more unpredictable, this increasing the chance of outage.

The document WO 2015/078716 A1 shows a method for localizing partial discharges in electricity cables. A voltage of 100 kV is applied here in active manner by a high-voltage source to a cable for testing at an uncoupled end thereof so as to thus cause partial discharges. Using a sensor unit pulses caused by the partial discharge are then detected by measuring the current. The cable has to be taken out of use when performing this method, this being undesirable for instance because of outage of power supply.

The document EP 1 094 324 A2 describes a method for localizing partial discharges which cause a pulse in an electrical system, wherein characteristic parameters are defined which describe the shape of a single pulse and provide information about the location of the discharge. In order to be able to define the characteristic parameters the pulse has to be measured at such a large signal-to-noise ratio that in practice the method has the drawback of being prone to failure.

Provided in a first aspect according to the present patent application is a method for detecting abnormalities in a power cable which is in use and comprises one or more conductive cores, comprising the following steps of:
- dividing the power cable of a determined length into a number of cable sections of shorter length;
- determining a section pattern of signals occurring in a section when the insulation of a core shows an abnormality;
- measuring the magnitude of signals over time in a determined frequency band; and
- designating a cable section with an abnormality when the measured signals match the section pattern determined for the cable section.

This method provides information about the condition of power cables. Through ascertaining whether abnormalities or disturbances are present it is more easily possible to determine where maintenance must take place. It does after all become possible to determine the location of the possible abnormalities/disturbances in the cable, so creating the possibility of carrying out preventive management. Only a part of the cable need for instance be replaced here.

The above described method is advantageous compared to the above cited documents because the method is performed when the cable is in use and in passive manner, i.e. without an external voltage having to be applied, and because, by determining among other things a section pattern of signals, the cable section with an abnormality is designated when the measured signals match one of the section patterns.

It is a further advantage of the method that the impedance of the cable sections can be determined over time using the measured signals. Determining the impedance of the cable and changes thereof makes it possible inter alia to provide information about the cable temperature.

According to preferred embodiments of this method the measured signals preferably comprise signals originating from one or more abnormalities in one or more cable sections of the cable, wherein the signals are propagated in both longitudinal directions of the cable and at a specific velocity through the one or more conductive cores of the cable and are reflected at cable ends or other changes in impedance. The longer a signal is propagated over the cable and the more often a signal is reflected, the greater will be the decrease in the magnitude or amplitude of the signal. The signals can occur due to different mechanisms in the case of abnormalities. A pulse can for instance thus occur in a determined cable part when a discharge (short-circuit) takes place, an impedance variation can occur in a cable section, or noise can be generated in a cable section, for instance due to a reduction in the leakage resistance. The reduction in the leakage resistance can be caused by, among other factors, damage to the cable sheath or other damage to the cable caused for instance by mechanical load.

The signals are preferably measured at one location of the cable, for instance close to cable ends in a transformer substation. The possibility of measuring at one location results from determining the section patterns of signals and reflections of signals, after which the measurement of all these signals gives a direct indication of the cable section with an abnormality.

The signals are preferably measured in measured values of for instance the magnetic field, the current through the cores of the cable and/or the voltage. A contactless, i.e. passive, measurement of the voltage is more preferably made by for instance a capacitive measurement, when the cable has no electromagnetic shielding. Most preferably measured is the magnetic field, since this can be done in contactless manner by means of inductive measurement of the magnetic field induced by the current passing through the cable. The current can be calculated when the magnetic field is measured.

The cable sections preferably have a length of 1 to 40 metres. The resolution achieved depends on, among other factors, properties of the cable and the measurement, such as the length of the cable and the frequency band in which measurement takes place.

Measurement preferably takes place in a frequency band of 50 Hz to 10 GHz, more preferably 50 Hz to 1 GHz, for instance 50 Hz to 100 MHZ, 50 Hz to 10 MHZ, 50 Hz to 1 MHZ and 50 Hz to 100 kHz. The maximum frequency to be used depends on, among other factors, the desired length of the cable sections. The shorter the cable section, the higher will be the frequency. In addition, there will possibly be more signals seen in the measured values at a high frequency.

The section pattern for each cable section is preferably determined by the signals being present at different times in the measured value, such as the magnetic field or the current, wherein the measured value comprises at different times the signal coming directly from a cable section with an abnormality and at least one of the reflections of the signal propagated in the first instance in the other direction and reflected at a cable end or other change in impedance. The times at which the signals are measured depend on the length of the cable and the signal propagation velocity in the cable. The propagation velocity depends on, among other factors, the permittivity of the insulation material of the sheaths of the cores and the cable and usually lies between 10% and 100% of the speed of light.

The section pattern for each cable section is preferably further determined by the relative magnitude of signals, wherein the magnitude of the signals becomes smaller as the propagation time over the cable increases. Each reflection brings about a reduction here in the signal magnitude.

When for instance the current is measured at one location, the signals which occur in a determined cable section will be present at different times in the measured current. When for instance a discharge takes place in a determined cable section, a signal will be propagated in the form of a pulse with a determined velocity in both longitudinal directions of the cable. At the location where measurement takes place, which for practical reasons is preferably situated in a transformer substation, the pulse propagated in the direction of the measuring location will be visible in the current at a specific point in time. The pulses will be reflected at locations in the cable where the impedance changes, such as at the cable ends. These reflections become visible at later times in the current measured at the measurement location. The pattern over time of the measured direct and reflected pulses is characteristic for the cable section where the original pulse occurred. It is therefore possible by measuring this pattern to determine the section of the cable in which there is an abnormality or disturbance, wherein three pulses provide sufficient information. It will be apparent that the above example relating to a pulse will also apply for other signals caused by abnormalities, such as noise, and for other measured values, such as the voltage.

The measured values are preferably analysed in order to determine measured values per core, wherein the signals are measured in the measured values per core.

The signals are preferably measured in a common mode and/or one or more differential modes in relation to the different cores. An advantage of measuring the signals in the various modes is that signals can become more readily visible or more signals can become visible compared to for instance measuring only in common mode. A further advantage of measuring in different modes is that it becomes possible to make use of the differences in signal propagation velocity between for instance common and differential modes.

A time difference is preferably measured between signals measured in the common mode and the one or more differential modes, wherein the designation of a cable section with an abnormality is also made using the determined time difference. Owing to the difference in propagation velocity a signal which has occurred in a cable section with an abnormality will be measured at different times at a measuring location in the different modes. The time difference between measured signals provides a further possibility of designating the cable section with an abnormality.

The designation of a defective cable section is preferably made using a time filter constructed using the signal patterns determined per cable section, whereby it is possible to look at signals which come from a predetermined cable section.

The method preferably further comprises, after the measuring step, of summating the signals falling within the determined section pattern per cable section, wherein designation further comprises of designating a defective cable section when the summated signals per cable section lie above a determined threshold value, or differ relative to an anticipated value, preferably when the summated signals of a cable section differ with a determined threshold value relative to the summated signals of other cable sections, for instance an average value or median of the summated signals of other cable sections. There are more preferably multiple threshold values in order to be able to apply multiple categories, such as for instance 'high priority', 'low priority' and 'no priority' in respect of replacement of a cable or cable section. Energy utilities can formulate the requirements, such as threshold values, depending on their preferences in respect of maintenance, type of cable etc. The summation of signals per cable section can reduce the amount of data and can be displayed locally, for instance on a screen panel.

The method preferably comprises of transmitting information about the status of one or more cables, wherein the step of summation ensures that the amount of data to be transmitted can be reduced.

The section pattern for each cable section and further cable characteristics are preferably determined by characterizing the cable by means of measurements on the cable for a determined time. Other options for finding cable characteristics comprise calculations or simulations on the basis of properties such as the length of the cable, the number of cores, the form of the cores and so on.

Provided in a second aspect according to the present patent application is a device for measuring a power cable, comprising:
- one or more magnetic sensors, wherein the magnetic sensors are configured to be arranged around the power cable and to measure the magnetic field over time in a determined frequency band;
- processor means for dividing the power cable of a determined length into a number of sections of shorter length, determining a section pattern of signals which occur in a section when the insulation of a core shows an abnormality, designating a cable section with an abnormality when the measured signals match the section pattern determined for the cable section; and
- memory means for storing the section patterns and measured values.

Although measurement using one sensor is possible, the device comprises according to preferred embodiments a number of sensors equal to the number of cores multiplied by one when the power cable comprises two or more cores.

The processor means are preferably configured to calculate the position of each core. The processor means are more preferably further configured to also calculate the current for each core from the measured magnetic field.

The device preferably comprises communication means for transmitting data, and the communication means more preferably also comprise means for receiving instructions or other data.

The device preferably further comprises means for capacitive measurement of the voltage.

The above and further preferred embodiments of methods and devices according to the present invention provide the option, for instance for grid operators, to save costs and provide among other things potential insight into the condition of the power cables (ageing, risk), the failure of power cables and potential outage locations.

Further advantages, features and details of the present invention will be elucidated with reference to the following description of figures relating to a preferred embodiment thereof, in which:
Fig. 1 is a schematic view of the impedance against the distance with corresponding propagation times of signals occurring in a first exemplary section of a power cable;
Fig. 2 is a view of the times at which the signals as in fig. 1 are measured;
Fig. 3 is a schematic view of the impedance against the distance with corresponding propagation times of signals occurring in a second exemplary section of a power cable;
Fig. 4 is a view of the times at which the signals as in fig. 3 are measured;
Fig. 5 shows a schematic example of measured intensity against time of signals occurring in the cable section as in fig. 2;
Fig. 6 shows a histogram of summated signals per cable section of fig. 1 and 3;
Fig. 7 shows an exemplary embodiment of a measuring unit with magnetic sensors of the device;
Fig. 8 is a top view of the exemplary embodiment of a measuring unit with magnetic sensors as in fig. 7;
Fig. 9 is a schematic view of a measurement of the magnetic field around a power cable with three cores; and
Fig. 10 is a schematic view of the different modes of a power cable with three and four cores.

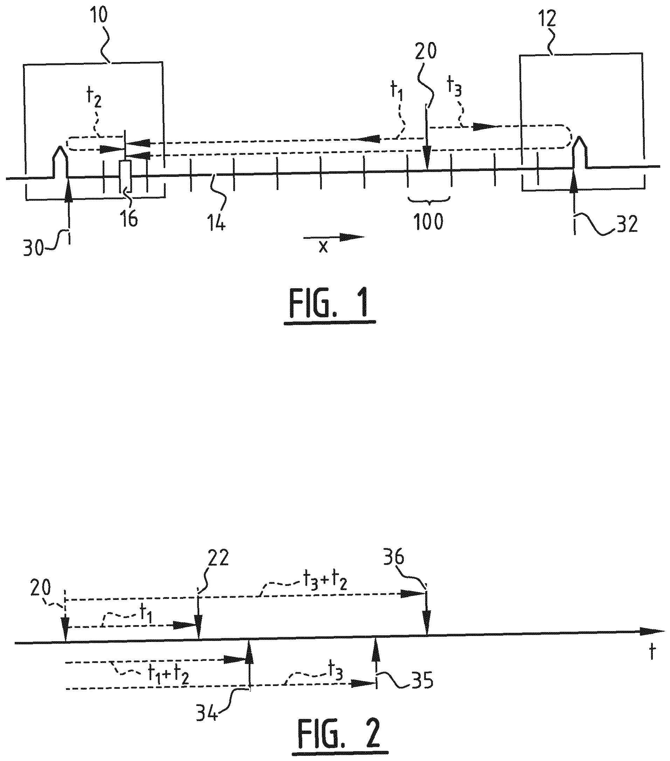

Shown schematically in figure 1 is the impedance against the distance, wherein a power cable, designated as cable 14, connects transformer substation A 10 to transformer substation B 12 and is divided into sections. The sections are indicated in the example of fig. 1 with the vertical lines intersecting cable 14. A cable with a length of for instance 400 metres will be divided into sections of for instance 1 metre depending on properties of the cable and the measurement, such as the length of the cable and the frequency band in which measurement takes place. A signal 20 occurs in cable section 100 and will be propagated in both longitudinal directions of cable 14. The signal propagated in the first instance in the direction of transformer substation A 10 will travel the distance between cable section 100 and measuring device 16 and will be measured by measuring device 16. A time t₁ relative to the occurrence of signal 20 corresponds to this distance being travelled. When for instance the propagation velocity and the distance travelled are equal to 95% of the speed of light and 400 m, t₁ is about 1.4 µs. The signal will propagate further and be reflected at cable end 30. This reflection will be measured by measuring device 16 at a time t₁ + t₂ after the occurrence of signal 20. The signal propagated in the first instance in the direction of transformer substation B 12 will be reflected at cable end 32 and then be further propagated in the direction of transformer substation A 10. The reflected signal will be measured at measuring device 16 at the time t₃ which has elapsed since the occurrence of signal 20.

The above sequence of the occurrence of signal 20 and the reflections thereof is further elucidated in fig. 2. Here the times at which the (reflected) signals are measured as in figure 1 are shown on a time axis. Signal 20 occurs at a determined point in time, after which the signal 22 propagating directly in the direction of transformer substation A is measured after time t₁. The reflection of the signal, measured signal 34, is measured at time t₁ + t₂ after occurrence of signal 20. Because t₂ is known due to the location of measuring device 16, it will be apparent due to the presence of signal 34 that in this example the cable section in which signal 20 has occurred is situated on the right-hand side of measuring device 12. A third signal 35 is measured after time t₃, wherein the signal has first been propagated in the direction of transformer substation B, has there been reflected at cable end 32 and subsequently propagated in the direction of measuring device 16. Following measurement of signal 35 there is sufficient information to calculate the cable section in which signal 20 has occurred. Further reflections, such as signal 36 measured at time t₃ + t₂, can also be measured depending on the measurement sensitivity and the intensity of the reflected signals. In view of the above, the times at which the different (reflected) signals are measured by measuring device 16 provide a pattern of the cable section, in this case cable section 100, in which the signal occurred in the first instance.

Further reflections of signal 20 present in the measured value can make measurement more difficult of signals, such as signal 20, which occur later. Since the cable section can be calculated after signal 35, it is also possible to predict and then filter out further reflections of signal 20 from the measured value. New signals can hereby be measured more easily.

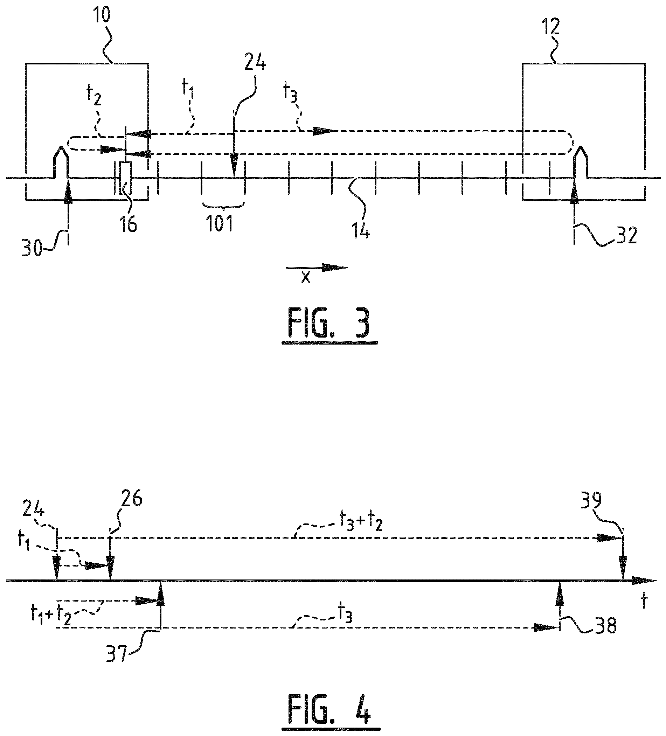

A different pattern is thus created when a signal 24 occurs due to an abnormality or defect present in another cable section 101 as shown in fig. 3. The signal propagated in the first instance in the direction of transformer substation A 10 will now first be measured at a specific point in time by measuring device 16, this at a time t₁ after the occurrence of signal 24. This signal will propagate further and be reflected at cable end 30. This reflection will be measured by measuring device 16 at a time t₁ + t₂ after the occurrence of signal 24. The signal propagated in the first instance in the direction of transformer substation B 12 will be reflected at cable end 32 and then be further propagated in the direction of transformer substation A 10. The reflected signal will be measured at measuring device 16 at the time t₃ which has elapsed since the occurrence of signal 24.

The above sequence of the occurrence of signal 24 and the reflections thereof is further elucidated in fig. 4. Here the times at which the (reflected) signals are measured as in fig. 3 are shown on a time axis. Signal 24 occurs at a determined point in time, after which the signal 26 propagating directly in the direction of transformer substation A is measured after time t₁. The reflection of signal 36 is measured at time t₁ + t₂ after the occurrence of signal 24. A third signal 37 is measured after time t₃, wherein the signal has first been propagated in the direction of transformer substation B, has there been reflected at cable end 32 and subsequently propagated in the direction of measuring device 16. A signal with origin cable section 101 thus provides a pattern clearly different from a signal with origin cable section 100. A cable section in which an abnormality is probably present can therefore be determined using one measuring device 16.

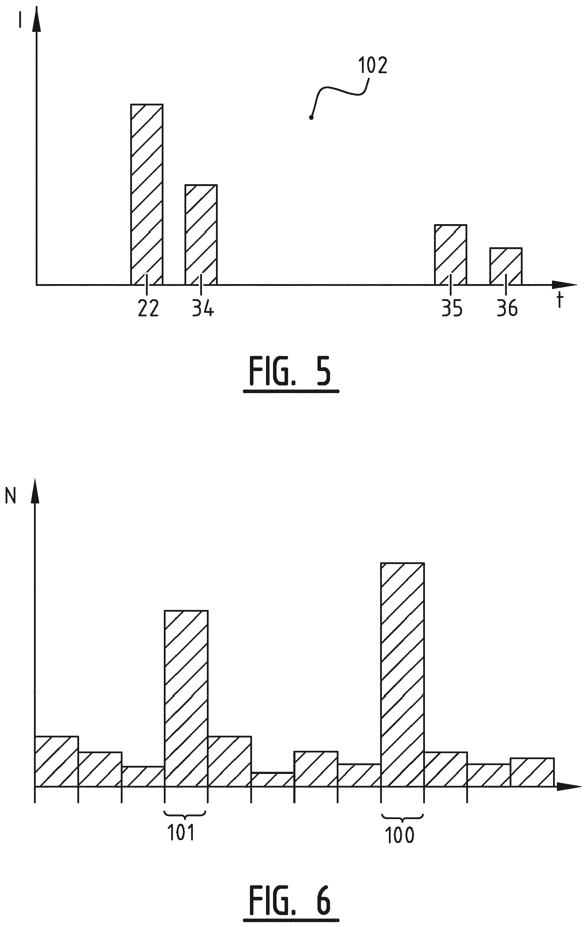

Fig. 5 shows the measured pattern 102 corresponding to cable section 100 on the basis of the measured intensity against the time. Pattern 102 is created by measuring the signals as in fig. 2 and 4. Signals 22, 34, 35 and 36 are measured here at determined times, this characterizing the cable section 100. The intensity of the different signals decreases at each successive reflection, wherein the decrease depends on the cable length, impedance and other properties of the cable. On the basis of the patterns, optionally including relative intensities, of the different cable sections filters can be made through which signals can be summated per cable section.

Fig. 6 shows an example of the summation of measured signals from a cable as in fig. 1 and 3 which is divided into twelve sections. In this example the cable has two sections 100, 101 which comprise one or more abnormalities. The summation of measured signals which match the pattern per section, with as example the pattern for section 100 as in fig. 5, is shown in the form of a histogram.

The measuring of signals and determining of data as in the histogram of fig. 5 can be performed by the device according to the second aspect of the present patent application, wherein the device is configured so that it can be applied inside a transformer substation. The amount of data can hereby be reduced locally relative to the values measured in the first instance, and this can take place at high frequency, for instance 1 MHZ or 200 MHZ. The measured data can also be converted to other reduced values depending on the information desired by the user. The vertical axis of fig. 6, shown as N, can for instance be the summated intensity of signals coming from the associated sections. It is for instance also possible to keep track of when the measured signals exceed a predetermined threshold value per section, after which N is increased for the section by a predetermined number.

The reduced data, such as the data of the histogram in fig. 6, can be sent periodically to a central point or to the user in order to thus be able to assess the status of a determined cable, in this example cable 14, and decide on the basis thereof whether maintenance is necessary.

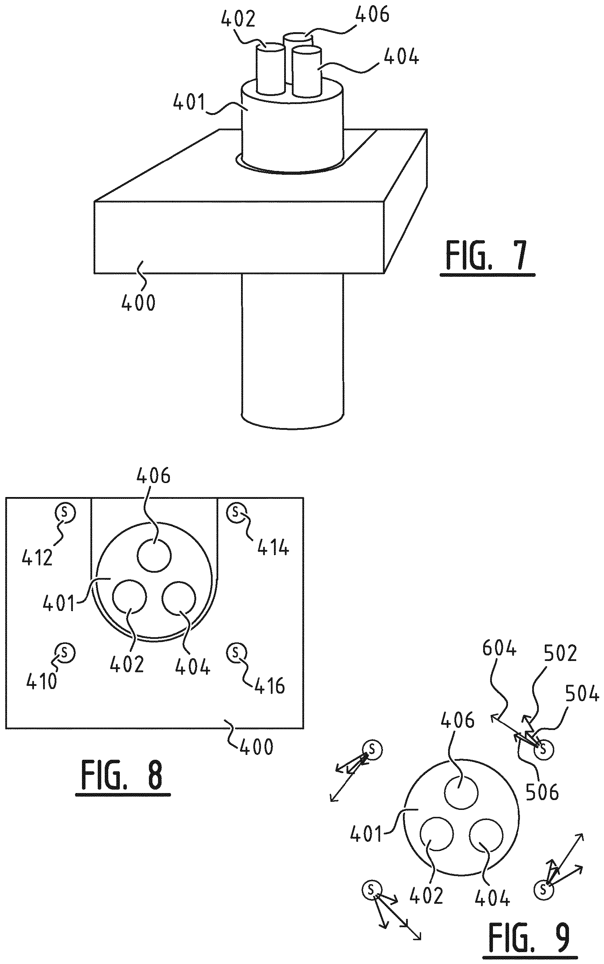

Fig. 7 and 8 show a preferred embodiment of a sensor unit 400 comprising magnetic sensors as described in the second aspect of the present patent application. In the top view of fig. 8 power cable 401 comprises three cores 402, 404, 406. Sensor unit 400 is arranged round cable 401 and comprises four sensors 410, 412, 414, 416 in order to measure the magnetic field around the cable by means of induction currents. These are sufficient measuring points for determining the current and position of the three cores 402, 404, 406. The form and size of the measuring device can be adapted subject to the application. The magnetic field can further be measured simultaneously per sensor in two directions, for instance substantially perpendicularly to each other.

Fig. 9 shows a schematic cross-section of power cable 401 with cores 402, 404, 406. The magnetic fields measured at the four sensors (designated with an 's') are shown with arrows which indicate the direction and magnitude of the magnetic field. The measured magnetic fields are the sum of the magnetic fields induced by each core. As shown schematically in fig. 9, measured magnetic field 604 is for instance the sum of magnetic fields 502, 504 and 506 induced by cores 402, 404 and 406, wherein magnetic fields 502, 504 and 506 are not shown to scale.

By measuring at in this example four locations for three cores the current and position of the three cores can be determined, since the magnetic field induced by the cores and measured by the sensors is proportional to the current and the inverse of the distance from the respective core, as will be known to the skilled person.

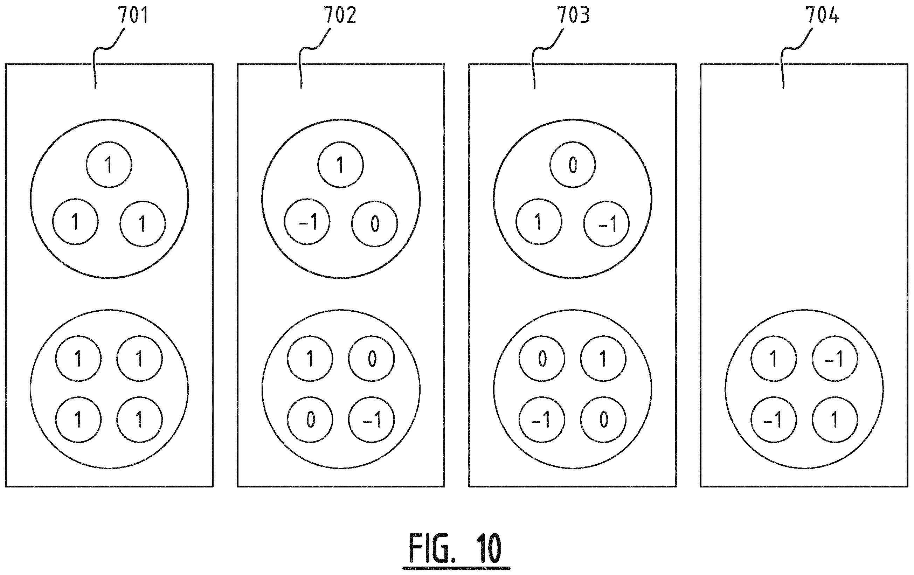

Shown schematically in fig. 10 are the different modes in which measurement can take place. The measured values of the cores are multiplied by the numbers (1 or -1) shown inside the cores, and then summated. Box 701 shows common modes for cables with three and four cores, wherein the measured values of all cores present are added together. Boxes 702, 703 and 74 show examples of differential modes, wherein the propagation velocity is other than that for the common mode 701. The differential mode for the cable with four cores shown in box 704 has a propagation velocity other than that for the differential modes of boxes 702 and 703.

When a cable has no loss the signal propagation velocity is v = (L·C)^{-0,5}, wherein due to the coupling between the cores the induction L and capacitance C are matrices. The coupling therefore causes different propagation velocities for the different modes. The velocities for the different modes can be calculated using the eigenvalues of the product of the matrices L and C. Here L·C = T·V·T⁻¹, wherein V is a diagonal matrix with the eigenvalues of L·C therein and T is a transformation matrix. The signal propagation velocities can be calculated with v = (V)^{-0.5}, wherein a velocity is found per eigenvalue, i.e. per mode.

A calculation example for direct current of the different propagation velocities for a low-voltage cable (type V-VMvKhsas 0.6/1 kV NEN 3616) with four cores has the following indicative result. The velocity of the differential mode 704 in fig. 10 is in this example 0.32xc, wherein c is the speed of light, while the propagation velocity in the differential modes 702 and 703 is equal to 0.30xc. In this calculation example the propagation velocity of the common mode 701 is equal to 0.40xc, higher than the other modes 702-704. The propagation velocities depend on, among other factors, cable properties such as the insulation material used around the cores and can differ per cable. The velocity for the common mode could for instance also be lower than the velocities of the differential modes. In addition, the propagation velocities for alternating current will also differ relative to this calculation example for direct current.

Due to the difference in propagation velocity of the various modes a signal is measured at different times for the various modes. The time difference between the measured times for the various modes gives a direct indication of the cable section where the original signal occurred.

The present invention is not limited to the above described preferred embodiments thereof; the rights sought are defined by the following claims, within the scope of which many modifications can be envisaged.

## Claims

1. Method for detecting abnormalities in a power cable (electricity) which is in use, preferably a medium voltage cable, for instance suitable for a voltage of 10 kV, and which comprises a plurality of conductive cores, comprising the following steps of:
- dividing the power cable of a determined length into a number of cable sections of shorter length;
- determining a section pattern of signals occurring in a section when the insulation of a core shows an abnormality, wherein the section pattern for each cable section is determined by the signals being present at different times in the measured value;
- measuring the magnitude of signals over time in a determined frequency band; and
- designating a cable section with an abnormality when the measured signals match the section pattern determined for the cable section,
wherein the signals are measured at one location, wherein the signals are measured in measured values of the magnetic field originating from the cable, wherein the signals are measured in a common mode and/or one or more differential modes in relation to the conductive cores.

2. Method as claimed in claim 1, wherein the measured signals comprise signals originating from one or more abnormalities in one or more cable sections of the cable, wherein the signals are propagated in both longitudinal directions of the cable and at a certain velocity through the one or more conductive cores of the cable and are reflected at cable ends or other changes in impedance.

3. Method as claimed in claim 1 or 2, wherein the measured values are analysed in order to determine the measured values per core, wherein the signals are measured in the measured values per core.

4. Method as claimed in claim 1, further comprising of determining a time difference between signals measured in the common mode and the one or more differential modes, wherein the designation of a cable section with an abnormality is also made using the determined time difference.

5. Method as claimed in any of the claims 1 to 4, wherein measurement takes place in a frequency band of 50 Hz to 10 GHz, more preferably 50 Hz to 1 GHz.

6. Method as claimed in any of the claims 1 to 5, wherein the measured value comprises at different times the signal coming directly from the cable section with an abnormality and at least one of the reflections of the signal propagated in the first instance in the other direction and reflected at a cable end or other change in impedance.

7. Method as claimed in any of the claims 1 to 6, wherein the designation of a defective cable section is made using a time filter constructed using the signal patterns determined per cable section.

8. Method as claimed in any of the claims 1 to 7, wherein the method further comprises, after the measuring step, summating the signals falling within the determined section pattern per cable section; and
wherein the designating further comprises designating a defective cable section when the summated signals of a cable section differ with a determined threshold value relative to the summated signals of other cable sections.

9. Method as claimed in any of the claims 1 to 8, wherein the method further comprises transmitting information about the status of one or more cables.

10. Method as claimed in any of the claims 1 to 9, wherein the section pattern for each cable section and further cable characteristics are determined by characterizing the cable by means of measurements on the cable for a determined time.

11. Device for measuring a power cable, comprising:
- one or more magnetic sensors, wherein the magnetic sensors are configured to be arranged around the power cable and to measure the magnetic field over time in a determined frequency band;
- processor means for dividing the power cable of a determined length into a number of sections of shorter length, determining a section pattern of signals which occur in a section when the insulation of a core shows an abnormality, designating a cable section with an abnormality when the measured signals match the section pattern determined for the cable section; and
- memory means for storing the section patterns and measured values.

12. Device as claimed in claim 11, wherein the device comprises a number of sensors equal to the number of cores increased by one when the power cable comprises two or more cores, wherein the processor, as well as calculating the current passing through each core, also calculates the position of the cores.
